# EUROPEAN PATENT APPLICATION

(11) **EP 4 528 827 A1**
(43) Date of publication of application: **26.03.2025**
(21) Application number: 23900304.9
(22) Date of filing: 12.10.2023
(51) Int. Cl.: H01L 31/0443, H10K 30/40, H10K 39/10

(54) **PHOTOELECTRIC CONVERSION MODULE**

(30) Priority: 05.12.2022 JP 2022194516
(71) Applicant: Enecoat Technologies Co.,Ltd., Kyoto 613-0031 (JP)
(72) Inventor: TAKAHAMA, Tsuyoshi, Kuse-gun, Kyoto 613-0031 (JP); NAKAMICHI, Shinji, Kuse-gun, Kyoto 613-0031 (JP)
(74) Representative: Hoffmann Eitle
(86) International application number: PCT/JP2023/037046
(87) International publication number: WO 2024/122182

(57) **Abstract**

An object of the present invention to provide a photoelectric conversion module having a bypass diode function without losing flexibility. To achieve the object, that present invention provides a photoelectric conversion module (10) including a power generation section and a bypass section. Each of the power generation section and the bypass section includes a first electrode (12), a photoelectric conversion layer (14), and a second electrode (12), the first electrode (12), a photoelectric conversion layer (14), and the second electrode (16) are laminated in the described order, each of the power generation section and the bypass section has a diode function, and diode direction in the power generation section and the bypass section is opposite to each other in a plane parallel to a light-receiving surface.

## Description

### TECHNICAL FIELD

The present invention relates to a photoelectric conversion module.

### BACKGROUND ART

In recent years, photovoltaic power generation has been attracting attention as clean energy and the development of solar cells is progressing. As part of this, solar cells using a perovskite material for a light absorption layer are rapidly gaining attention as next-generation type solar cells that can be manufactured at low costs. For example, Non-Patent Literature 1 reported a solution-processed solar cell using a perovskite material for a light absorbing layer. Further, Non-Patent Literature 2 reported that a solid-state perovskite solar cell exerts high efficiency. As a module structure of amorphous silicon solar cells, dye-sensitized solar cells, organic thin-film solar cells, and perovskite solar cells, a structure where cells are connected in series has been frequently reported.

### Citation List

### Non-Patent Literature

Non-Patent Literature 1: Journal of the American Chemical Society, 2009, 131, 6050-6051.
Non-Patent Literature 2: Science, 2012, 388, 43-647.

### Patent Literature

Patent Literature 1: JP 2000-277785A

### SUMMARY OF INVENTION

### Technical Problem

However, when a part of the solar cells is shaded, the generated current becomes ununiform, and where there is a series-connection structure, the power generation of solar cells decreases extremely. Further, depending on the load condition of the solar cell module, a large reverse bias voltage is applied to the shaded part of the cells, such that the cells are overheated due to a phenomenon called hot spots. The occurrence of hot spots may even result in the breakdown of the cells. Therefore, in order to avoid this hot-spot phenomenon, a method of preventing overheating of the cells by providing a bypass diode has been proposed (Patent Literature 1). However, attachment of conventional bypass diodes to the solar cells increases the thickness of the solar cells and hinders flexibility or the like, which is a characteristic of the thin-film solar cells.

Hence, it is an object of the present invention to provide a photoelectric conversion module having a bypass diode function without losing flexibility.

### Solution to Problem

To achieve the above object, the present invention provides a photoelectric conversion module including a power generation section and a bypass section, wherein each of the power generation section and the bypass section includes a first electrode, a photoelectric conversion layer, and a second electrode, wherein the first electrode, the photoelectric conversion layer, and the second electrode are laminated in the described order, wherein each of the power generation section and the bypass section has a diode function, and wherein directions of a diode in the power generation section and that in the bypass section are opposite to each other in a plane parallel to a light-receiving surface.

### Advantageous Effects of Invention

The present invention can provide a photoelectric conversion module having a bypass diode function without losing flexibility.

### BRIEF DESCRIPTION OF DRAWINGS

[FIG. 1] FIG. 1 is a cross-sectional view showing a direct structure of a photoelectric conversion module according to an embodiment of the present invention.
[FIG. 2] FIG. 2 is a cross-sectional view showing an inverted structure of a photoelectric conversion module according to an embodiment of the present invention.

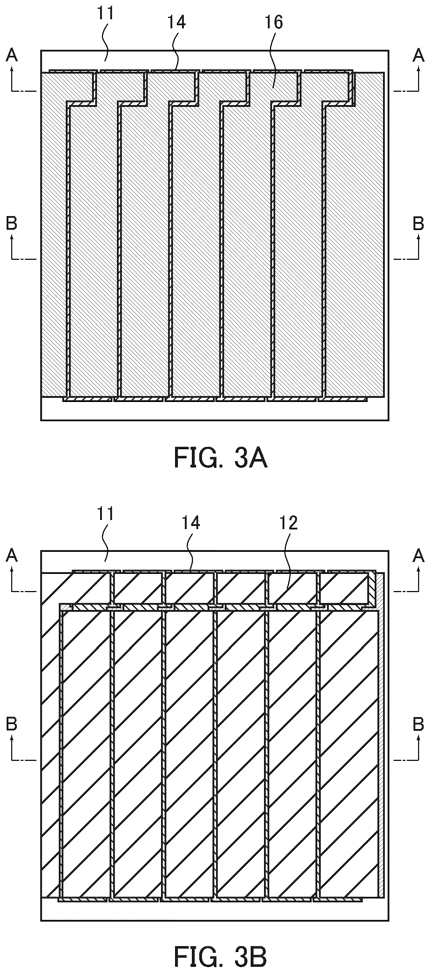

[FIG. 3A] FIG. 3A shows a pattern of the photoelectric conversion module according to Example 1 of the present invention viewed from a surface opposite to a surface of the support.
[FIG. 3B] FIG. 3B shows a pattern of the photoelectric conversion module according to Example 1 of the present invention viewed from the surface of the support.
[FIG. 4] Fig. 4 is a cross-sectional view showing connection of the bypass section according to the examples of the present invention, taken along the line A-A in FIGs. 3A and 3B.
[FIG. 5] FIG. 5 is a cross-sectional view showing connection of the power generation section according to the examples of the present invention, taken along the line B-B in FIGs 3A and 3B.

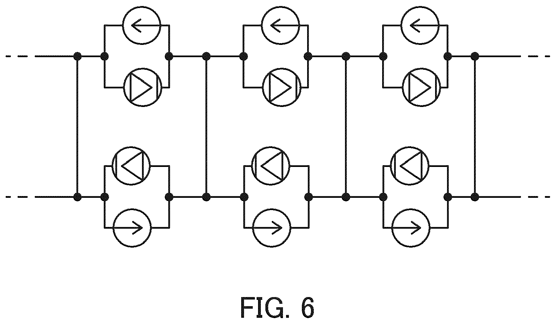

[FIG. 6] FIG. 6 shows an equivalent circuit according to the examples of the present invention.
[FIG. 7] FIG. 7 shows a pattern of the first electrode according to Example 1 of the present invention.
[FIG. 8] FIG. 8 shows a pattern of the photoelectric conversion layer on the first electrode according to Example 1 of the present invention.
[FIG. 9] FIG. 9 shows a pattern of the second electrode on the photoelectric conversion layer according to Example 1 of the present invention.
[FIG. 10] FIG. 10 shows the light-receiving surface of the photoelectric conversion module according to Example 1 of the present invention attached with a mask.
[FIG. 11] FIG. 11 shows a state where one of the cells of the photoelectric conversion module according to Example 1 of the present invention is shaded.
[FIG. 12] FIG. 12 shows a pattern of the first electrode according to the comparative example.
[FIG. 13] FIG. 13 shows a pattern of the photoelectric conversion layer on the first electrode according to the comparative example.
[FIG. 14] FIG. 14 shows a pattern of the photoelectric conversion layer on the second electrode according to the comparative example.
[FIG. 15] FIG. 15 is the light-receiving surface of the photoelectric conversion module according to the comparative example attached with a mask.
[FIG. 16] FIG. 16 shows a state where one of the cells of the photoelectric conversion module according to the comparative example is shaded.
[FIG. 17] FIG. 17 shows a pattern of the first electrode according to Example 2 of the present invention.
[FIG. 18] FIG. 18 is the photoelectric conversion layer according to Example 2 of the present invention.
[FIG. 19] FIG. 19 shows a pattern of the second electrode according to Example 2 of the present invention.
[FIG. 20] FIG. 20 is the light-receiving surface of the photoelectric conversion module according to Example 2 of the present invention attached with a mask.
[FIG. 21] FIG. 21 shows a state where one of the cells of the photoelectric conversion module according to Example 2 of the present invention is shaded.

### DESCRIPTION OF EMBODIMENTS

The present invention will be described in more detail with reference to examples. However, the present invention is not limited to the following description.

In the present invention, unless otherwise specified, "mass%" and "wt%" may be used interchangeably, and "pts.mass " and "pts.wt." may be used interchangeably.

In the present invention, "on" or "on a surface of" may refer to a state of contact on or on a surface of an object directly or via other components or the like.

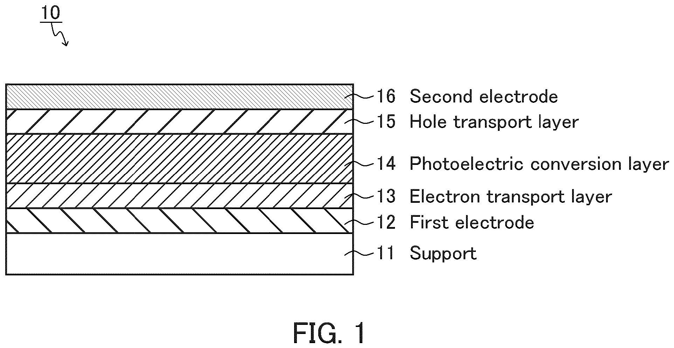

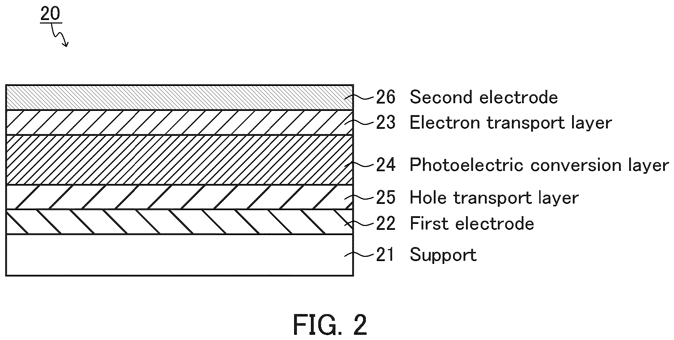

As described above, the photoelectric conversion module (hereinafter sometimes merely referred to as the "module") of the present invention includes, for example, a power generation section and a bypass section. Each of the power generation section and the bypass section includes a first electrode, a photoelectric conversion layer, and a second electrode. The first electrode, the photoelectric conversion layer, and the second electrode are laminated in the described order. In the photoelectric conversion module of the present invention, for example, each of the power generation section and the bypass section may further include a support. Herein, between the first electrode and the photoelectric conversion layer, a component other than the first electrode, the photoelectric conversion layer, the second electrode, and the support (hereinafter merely referred to as an "other component") may be included. Between the photoelectric conversion layer and the second electrode, another component may be included. Examples of the other component include an electron transport layer, and a hole transport layer. The photoelectric conversion module of the present invention may have either the direct structure described in FIG. 1, or the inverted structure described in FIG. 2. The direct structure is a structure in which the support, the first electrode, the electron transport layer, the photoelectric conversion layer, the hole transport layer, and the second electrode are formed in this order from the support side that receives the incident light. In contrast, the inverted structure is a structure in which the support, the first electrode, the hole transport layer, the photoelectric conversion layer, the electron transport layer, and the second electrode are formed in this order from the support side that receives the incident light.

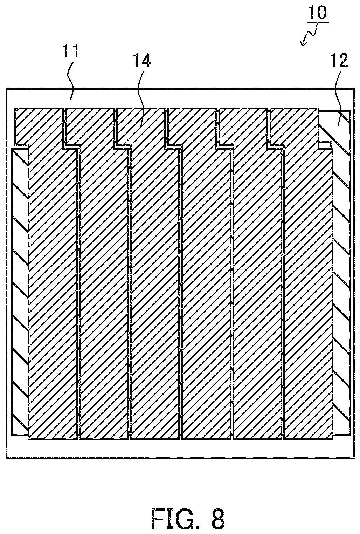

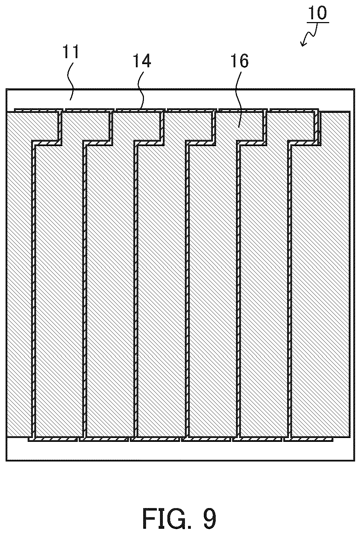

In the power generation section and the bypass section of photoelectric conversion module of the present invention, for example, at least one of the first electrode, the photoelectric conversion layer, or the second electrode may be formed of the same material to each other. That is, the power generation section and the bypass section may share with each other, at least one of the first electrode, the photoelectric conversion layer, or the second electrode. When the photoelectric conversion module of the present invention includes the support, for example, in the power generation section and the bypass section, at least one of the support, the first electrode, the photoelectric conversion layer, and the second electrode may be formed of the same material to each other. That is, the power generation section and the bypass section may share with each other, at least one of the support, the first electrode, the photoelectric conversion layer, or the second electrode. As shown in FIG. 8, for example, the photoelectric conversion layer 14 in the power generation section and the photoelectric layer 14 in the bypass section may be formed of the same material as one another. As shown in FIG. 9, for example, the second electrode in the power generation section and the second electrode in the bypass section may be formed of the same material as one another .

### <Series module>

Conventional photoelectric conversion modules connected in series can reduce the current density flowing through transparent electrodes, and thus make the transparent electrodes less affected by the resistance. In conventional photoelectric conversion modules, when a part of the module is shaded during power generation, the generated current becomes ununiform, and the drop rate of the output may increase more than the area of the shaded part. When the systems are connected in parallel, a reverse bias may be applied to the shaded cells depending on the load conditions. In such a case, if there is any slight defect, a so-called hot spot occurs, which may cause large damage to the photoelectric conversion module. As a conventional solution, a method of parallelly sandwiching each cell with ohmic resistors or the like has been proposed. However, in this case, there was still a problem in that a small resistance can cause a large leakage, which results in the drop in output itself, while a large resistance can cause a reverse bias voltage applied to the shaded cells. In order to solve this problem, a method of attaching a bypass diode has been considered. A commonly used bypass diode is a diode incorporated in a photoelectric conversion module, which is connected in parallel with a series circuit of the cells, to bypass a circuit that has become incapable of generating power due to the influences of shades, failures, or the like. In the present invention, a diode that is in the opposite direction to the current flowing through the cell is provided for each cell on the same plane where the cell exists. That is, in the photoelectric conversion module of the present invention, in a plane parallel to the light-receiving surface, the diode direction of the power generation section and that of the bypass section are opposite to each other. In the study of the present invention, the inventors of the present invention have reached the invention that realizes the same function as bypass diodes without additional materials or processes, by changing the pattern of the module.

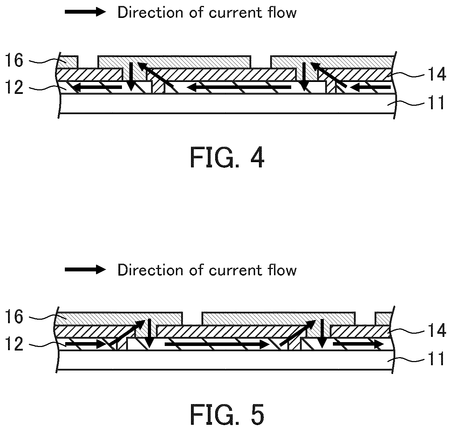

In the present invention, the pattern of the bypass section needs to have a diode in a direction opposite to the power generation section. A diode is a semiconductor configured to allow the current to flow in the forward direction to the voltage application but restrict the current in the reverse direction. In the present invention, the bypass section (section having a bypass diode function) is a part where the current flows in the opposite direction to the power generation section (section contributing to power generation). In the bypass section of the present invention, the light incidence makes the current flow in the opposite direction, and thereby the power is generated. FIG. 4 and FIG. 5 show current flows in the bypass section and the power generation section. When the light enters the bypass section, as shown in FIG. 4 and FIG. 5, the current flows through the bypass section in the opposite direction to the power generation section, so that the currents of the cells cancel each other. Therefore, the area of the bypass section is desired to be smaller than that of the power generation section. Further, it is more desirable that the light incidence to the bypass section is shielded. Accordingly, it is possible to steadily shield the light by placing the bypass section in a frame supporting the photoelectric conversion module of the present invention.

The photoelectric conversion module of the present invention includes a semiconductor layer (photoelectric conversion layer) such as perovskite sandwiched between the electron transport layer and the hole transport layer, and thus has a function equivalent to a p-n diode (precisely a pin diode) of general semiconductors. Taking the electrode connected to the electron transport layer side in the dark as a zero potential, the application of positive voltage to an electrode connected to the hole transport layer side causes the forward-direction state, and the current flows. The application of negative voltage causes the negative-direction state, thereby effecting a diode which makes the current hard to flow.

The photoelectric conversion module with a larger cell area is more advantageous for power generation. However, it is necessary to prevent overheating due to the current flowing into the bypass section. Therefore, the area ratio S (Sb/Sp) between the total area of the plane parallel to the light-receiving surface in the power generating unit (Sp) and the total area of the plane parallel to the light-receiving surface in the bypass section (Sb) is preferably 0.001 to 0.2, and more preferably 0.01 to 0.15.

The present invention will be described in more detail with reference to embodiments. However, the present invention is not limited to the following embodiments.

### [Photoelectric conversion module]

The photoelectric conversion module of the present invention may have, for example, either the direct structure in which the first electrode, the electron transport layer, the photoelectric conversion layer, the hole transport layer, and the second electrode are laminated in this order, or the inverted structure in which the first electrode, the hole transport layer, the photoelectric conversion layer, the electron transport layer, and the second electrode are laminated in this order, as described above. The photoelectric conversion module of the present invention may or may not necessarily include, for example, a component other than the first electrode, the hole transport layer, the photoelectric conversion layer, the electron transport layer, and the second electrode. For example, the first electrode, and the electron transport layer or the hole transport layer may be directly laminated without any other component interposed therebetween, or may be laminated via another component. Similarly, the electron transport layer or the hole transport layer, and the photoelectric conversion layer may be directly laminated without any other component interposed therebetween, or may be laminated via another component. Similarly, the photoelectric conversion layer, and the hole transport layer or the electron transport layer may be directly laminated without any other component interposed therebetween, or may be laminated via another component. Similarly, the hole transport layer or the electron transport layer, and the second electrode may be directly laminated without any other component interposed therebetween, or may be laminated via another component.

Hereinafter, the configuration and each component of the photoelectric conversion module of the present invention will be more specifically described with reference to embodiments. However, the photoelectric conversion module of the present invention is not limited to the following embodiments. Note that, described in the following is mainly a case where the photoelectric conversion module of the present invention is a solar cell.

FIG. 1 and FIG. 2 respectively shows a configuration of a photoelectric conversion module according to an embodiment of the present invention. Note that FIG. 1 and FIG. 2 are schematically illustrated with appropriate omission, exaggeration, or the like for the convenience of description. As shown in FIG. 1, in a photoelectric conversion module 10, a first electrode 12, an electron transport layer 13, a photoelectric conversion layer 14, a hole transport layer 15, and a second electrode 16 are laminated in this order on a support (also referred to as a substrate or a base material) 11. As shown in FIG. 2, in a photoelectric conversion module 20, a first electrode 22, an electron transport layer 23, a photoelectric conversion layer 24, a hole transport layer 25, and a second electrode 26 are laminated in this order on a support (also referred to as a substrate or a base material) 21.

### [Support 11, 21]

Supports 11 and 21 are not particularly limited and may be, for example, an appropriate substrate that can be used in general photoelectric conversion modules such as solar cells. Examples of the substrate include glass, a plastic plate including a plastic film, a plastic membrane, and an inorganic crystal substance. The thickness of the substrate is not particularly limited and is, for example, the thickness that does not hinder the flexibility of the photoelectric conversion module of the present invention. As used herein, "flexible" means, for example, being soft enough to avoid breaking, cracking, or the like after applying stress to the photoelectric conversion module of the present invention so that the performance of the photoelectric conversion module is not affected. In the case where the substrate is glass, for example, the thickness is preferably 0.5 to 1.1 mm. In the case where the substrate is a plastic film, for example, the thickness is preferably 50 to 125 µm. Further, a substrate with at least one type of a metal film, a semiconductor film, a conductive film, or an insulating film formed on a part or all of the substrate surface can also be suitably used as the supports 11 and 21. The size, the thickness, and the like of the supports 11 and 21 are not particularly limited, and may be, for example, the same as or based on general photoelectric conversion modules such as solar cells.

### [First electrode 12, 22]

The first electrodes 12 and 22 are layers having a function of, for example, supporting the electron transport layer 13 and the hole transport layer 25, and taking out electrons or holes from the photoelectric conversion layers 14 and 24. The first electrode 12 is a layer that functions as an anode (negative electrode). The first electrode 22 is a layer that functions as a cathode (positive electrode).

The first electrodes 12 and 22 may be, for example, respectively formed directly on the supports 11 and 21. The first electrodes 12 and 22 may be, for example, a transparent electrode formed of a conductor. Non-limiting examples of the transparent electrode include indium tin oxide (ITO) film, impurity-doped indium oxide (In₂O₃) film, impurity-doped zinc oxide (ZnO) film, fluorine-doped tin dioxide (FTO) film, a laminated film formed by laminating two or more of these films, gold, silver, copper, aluminum, tungsten, titanium, chromium, nickel, and cobalt. These layers may be used alone, or two or more of these may be used in a mixture, as a single layer or a lamination layer. These films may function as, for example, a diffusion prevention layer. The thickness of the first electrodes 12 and 22 is not particularly limited and preferably adjusted, for example, so that the sheet resistance is 5 to 15 Ω/□ (per unit area). A method for forming the first electrodes 11 and 22 is not particularly limited, and for example, a known film-forming method may be employed depending on a material to be formed. The form of the first electrodes 12 and 22 is not particularly limited either and may be, for example, a film-like form, or a lattice-like form such as a mesh-like form. A method for forming the first electrodes 12 and 22 respectively on the supports 11 and 21 is not particularly limited and may be a known method for example, and is preferably, for example, vacuum film forming, for example vacuum deposition and sputtering, etc. The first electrodes 12 and 22 that have been patterned may be used. A patterning method is not particularly limited and may be, for example, laser pattering, a method of immersion in an etching solution, and a patterning method using a mask in vacuum film forming. Any of these methods may be used in the present invention. The first electrodes 12 and 22 may be used in combination with metal wiring or the like for the purpose of lowering the electrical resistance value. The material of the metal wiring (metal lead wire) is not particularly limited and may be, for example, aluminum, copper, silver, gold, platinum, nickel and the like. The metal lead wire can be used in combination by forming the metal lead wire on the first substrate by, for example, deposition, sputtering, crimping, or the like, and providing a layer of ITO or FTO thereon, or forming the metal lead wire on ITO or FTO.

### [Hole transport layer 15, 25]

Hole transport layers 15 and 25 are layers having a function of transporting electric charges. For the hole transport layers 15 and 25, for example, a conductor, a semiconductor, an organic hole transport material, or the like can be used. The organic hole transport material can function as a hole transport material that receives holes from the perovskite layers (photoelectric conversion layers) 14 and 24 and transports the holes. As the conductor and the semiconductor, an inorganic hole transport material or the organic hole transport material is used. Examples of the inorganic hole transport material includes a compound semiconductor including monovalent copper, for example,CuI, CuInSe₂, and CuS, and a compound including metal other than copper, for example, GaP, NiO, CiO, FeO, Bi₂O₃, MoO₃, and Cr₂O. Among these, from the viewpoint of receiving only holes more efficiently to achieve a high hole mobility, the semiconductor including monovalent copper is preferable, and CuI or CuSCN is more preferable. Examples of the organic hole transport material include polythiophene derivatives, for example,poly-3-hexylthiophene (P3HT) and polyethylene dioxythiophene (PEDOT); fluorene derivatives, for example, 2,2',7,7'-tetrakis-(N,N-di-p-methoxyphenylamine)-9,9'-spirobifluorene (Spiro-OMeTAD); carbazole derivatives, for example, polyvinylcarbazole; triphenylamine derivatives, for example, poly[bis(4-phenyl)(2,4,6-trimethylphenyl)amine] (PTAA); diphenylamine derivatives; polysilane derivatives, and polyaniline derivatives. Among these, from the viewpoint of receiving only holes more efficiently to achieve a high hole mobility, triphenylamine derivatives and fluorene derivatives are preferable, and PTAA and Spiro-OMeTAD are more preferable.

To further improve the hole transporting property, the organic hole transport material may include an oxidizing agent, for example, lithium bis (trifluoromethylsulfonyl) imide (LiTFSI), silver bis (trifluoromethylsulfonyl) imide, zinc bis (trifluoromethylsulfonyl), ammonium bis (trifluoromethanesulfonyl) imide, lithium bis (nonafluorobutanesulfonyl) imide, sodium bis (nonafluorobutanesulfonyl) imide, lithium nonafluoro-N-[(trifluoromethane) sulfonyl] butanesulfonyl amide, potassium nonafluoro-N-[(trifluoromethane) sulfonyl]butanesulfonyl amide, nonafluoro-N-[(trifluoromethane)sulfonyl]butanesulfonyl amide, lithium N,N-hexafluoro-1,3-disulfonyl imide, sodium N,N-hexafluoro-1,3-disulfonyl imide, trifluoromethylsulfonyloxy silver, NOSbF₆, SbCl₅, SbF₅, and tris(2-(1H-pyrazole-1-yl)-4-tert-butylpyridine)cobalt(III)tri[bis(trifluoromethane)sulfonimide]. The hole transport layers 15 and 25 may include, for example, a basic compound, for example, tert-butylpyridine (TBP), 2-picoline, and 2,6-lutidine. The content of the oxidizing agent and the basic compound may be, for example, a conventional content in normal use. The film thickness of the hole transporting layers 15 and 25 is preferably, for example, 1 to 500 nm, and more preferably 2 to 300 nm, from the viewpoint of receiving more efficiently holes only to achieve a high hole mobility. A method for forming the hole transport layers 15 or 25 is preferably performed in, for example, a dry atmosphere. For example, it is preferable that a solution including an organic hole transport material is coated (spin coating or the like) on a perovskite layer (light absorption layer) in a dry atmosphere, and heated at 30 to 180°C, particularly 100 to 150°C.

Further, as the hole transport layer 25 in the inverted structure, for example, a hole transport compound forming a monomolecular layer (hereinafter also referred to as a "monomolecular hole transport compound") can be used. The monomolecular hole transport compound is desired to have, for example, an anchor that chemically bonds to ITO or the like, which is a transparent electrode, in the inverted structure. Examples of the anchor include a phosphonic acid group (-P=O (OH)₂), a carboxy group (-COOH), a sulfo group (-SO₃H), a boronic acid group (-B(OH)₂), a trihalogenated silyl group (-SiX₃, where X is a halogen atom), and a trialkoxysilyl group (-Si(OR)₃, where R is an alkyl group). Among these, the phosphonic acid group, the trihalogenated silyl group, and the trialkoxysilyl group are particularly preferred.

A method for forming the hole transport layer 25 using the monomolecular hole transport material is not particularly limited. The hole transport layer 25 can be formed, for example, by adsorbing the monomolecular hole transport compound to the first electrode 22 to form a monomolecular layer. A method for adsorbing the monomolecular hole transport compound to the first electrode 22 to form a monomolecular layer is not particularly limited and may be performed, for example, by dissolving the monomolecular hole transport compound in a solvent, and bringing the dissolved compound into contact with the first electrode 22 to bond them to each other. The bond between the monomolecular hole transport compound and the first electrode 22 is not particularly limited, and may be a physical bond or a chemical bond. The type of the bond is not particularly limited either and may be, for example, any of a hydrogen bond, an ester bond, and a chelate bond. The solvent for dissolving the monomolecular hole transport compound is not particularly limited either and may be, for example, one or both of water and an organic solvent. Specific examples of the solvent include water; alcohols, for example, methanol, ethanol, and 2-propanol; ethers, for example, diethyl ether, and diisopropyl ether; ketones, for example, acetone, and methyl isobutyl ketone; esters, for example, ethyl acetate, isobutyl acetate, and γ-butyrolactone; heterocycles, for example, tetrahydrofuran, and thiophene; amides, for example, N,N-dimethylformamide, N,N-dimethylacetamide, and N-methylpyrrolidone; sulfoxides, for example, dimethyl sulfoxide; sulfones, for example, diethyl sulfone, and sulfolane; nitriles, for example, acetonitrile, and 3-methoxypropionitrile; aromatic compounds, for example, benzene, toluene, and chlorobenzene; halogen-based solvents, for example, dichloromethane, and chloroform, and fluorine-based solvents, for example, chlorofluorocarbon, hydrochlorofluorocarbon, and hydrofluorocarbon. One of these may be used alone, or two or more of these may be used in combination.

A specific method for adsorbing the monomolecular hole transport compound to the first electrode 22 to form a monomolecular layer is not particularly limited, and examples thereof include known methods, for example, a dipping method, a spray method, a spin-coating method, and a bar-coating method. The temperature at the time of adsorption is not particularly limited, and is preferably -20 to 100°C, and more preferably 0 to 50°C. The time for adsorption is not particularly limited either, and is for example, preferably 1 second to 48 hours, and more preferably 10 seconds to 1 hour. Further, after the adsorption treatment, for example, washing may or may not necessarily be performed. A method for the washing is not particularly limited either, and for example, a known method may be appropriately used.

After the adsorption treatment or after the washing, heat treatment may or may not necessarily be performed. The temperature of the heat treatment is preferably 50 to 150°C, and more preferably 70 to 120°C. The time for the heat treatment is preferably 1 second to 48 hours, and more preferably 10 seconds to 1 hour. This heat treatment may be performed, for example, in an atmosphere or in vacuum.

When adsorbing the monomolecular hole transport compound to the first electrode 22, for example, a co-adsorbent may or may not necessarily be used in combination. The co-adsorbent can be added, for example, in a case where the electrode surface cannot be completely covered by the monomolecular hole transport compound alone, or for the purpose of inhibiting the interaction between the monomolecular hole transport compounds.

Non-limiting examples of the co-adsorbent include phosphonic acid compounds, for example, n-butylphosphonic acid, n-hexylphosphonic acid, n-decylphosphonic acid, n-octadecylphosphonic acid, 2-ethylhexylphosphonic acid, methoxymethylphosphonic acid, 3-acryloyloxypropylphosphonic acid, 11-hydroxyundesylphosphonic acid, and 1H,1H,2H,2H-perfluorophosphonic acid, acetic acid, propionic acid, isobutyric acid, nonanonic acid, fluoroacetic acid, α-chloropropionic acid, glyoxylic acid, and kenodeoxycholic acid. One of these may be used alone, or two or more of these may be used in combination.

A method for adsorbing the co-adsorbent to the first electrode 22 is not particularly limited, and preferably is a method of dissolving the co-adsorbent in a solvent for the adsorption, similarly to the monomolecular hole transport compound. The solvent is also not particularly limited either and may be, for example, the same as the solvent described above in the case of the monomolecular hole transport compound. For the adsorption of the co-adsorbent, the first electrode 22 may be immersed in a solvent in which the co-adsorbent is dissolved after adsorbing the monomolecular hole transport compound on a substrate, or a solution obtained by mixing and dissolving the co-adsorbent in an organic solvent together with the monomolecular hole transport compound may be used.

### [Electron transport layer 13, 23]

A material used for the electron transport layers 13 and 23 is not particularly limited and can be appropriately selected depending on the purpose, and is preferably a semiconductor material. The semiconductor material is not particularly limited and may be a known semiconductor material, for example, a single-element semiconductor, a compound semiconductor, or an organic n-type semiconductor.

The single-element semiconductor is not particularly limited and may be, for example, silicon, germanium, or the like.

The compound semiconductor is not particularly limited, and examples thereof include metal chalcogenides, specifically oxides, for example, titanium, tin, zinc, iron, tungsten, zirconium, hafnium, strontium, indium, cerium, yttrium, lanthanum, vanadium, niobium, and tantalum; sulfides, for example, cadmium, zinc, lead, silver, antimony, and bismuth; selenides, for example, cadmium, and lead, and tellurides, for example, cadmium. Examples of other compound semiconductors include phosphides, for example, zinc, gallium, indium, and cadmium, gallium arsenide, copper-indium-selenide, and copper-indium-sulfide

The organic n-type semiconductor is not particularly limited, and examples thereof include, perylenetetracarboxylic anhydride, perylenetetracarboxydiimide compound, naphthalenediimide-bithiophene copolymer, benzobisimidazobenzophenanthroline polymer, C₆₀, C₇₀, a flaran compounds such as PCBM ([6,6]-phenyl-C₆₁-butyric acid methyl ester), carbonyl bridge-bithiazole compounds, ALq₃ (tris(8-quinolinolato)aluminum), triphenylenebipyridyl compounds, silole compounds, and oxadiazole compounds.

Among the aforementioned materials used for the electron transport layers 13 and 23, the organic n-type semiconductor is particularly preferable.

For forming the electron transport layers 13 and 23, one of the materials may be used alone, or two or more of the materials may be used in combination. A crystal form of the semiconductor material is not particularly limited, and can be appropriately selected depending on the purpose, and may be monocrystalline, polycrystalline, or amorphous.

The film thickness of the electron transport layers 13 and 23 is not particularly limited and can be appropriately selected depending on the purpose, and is preferably 5 to 1000 nm, and more preferably 10 to 700 nm.

A method for forming the electron transport layers 13 and 23 is not particularly limited and can be appropriately selected depending on the purpose, and may be for example, a method of forming a thin film in a vacuum (vacuum film forming method), a wet film forming method, or the like. Examples of the vacuum film forming method include a sputtering method, a pulsed-laser deposition method (PLD method), an ion beam sputtering method, an ion-assisted method, an ion-plating method, a vacuum deposition method, an atomic layer deposition method (ALD method), and a chemical vapor deposition method (CVD method). The wet film forming method may be a method of formation performed by coating a solvent in which an electron transport material is dissolved, and a sol-gel method may be employed in the case of using an oxide semiconductor. The sol-gel method is a method performed by preparing a gel from a solution through a chemical reaction such as hydrolysis and polymerization or condensation, and then promoting densification by heat treatment. When employing the sol-gel method, a method for coating a sol solution is not particularly limited and can be appropriately selected depending on the purpose, and examples thereof include a dip method, a spray method, a wire bar method, a spin-coating method, a rollercoating method, a blade-coating method, and a gravure-coating method, and a wet printing method, for example, letterpress printing, offset printing, gravure printing, intaglio printing, rubber-plate printing, and screen printing. The temperature of the heat treatment after applying the sol solution is preferably 80°C or higher, and more preferably 100°C or higher.

In the case of the inverted structure, after forming the electron transport layer 23, an electron injection layer (hole blocking layer) may be formed between the electron transport layer 23 and the second electrode 26. The material used for the electron injection layer may be BCP (bathocuproine) to which cesium may be doped. The electron injection layer is preferably 1 to 100 nm, and more preferably 3 to 20 nm.

### [Photoelectric conversion layer 14, 24]

The photoelectric conversion layers 14 and 24 are not particularly limited, and may be, for example, the same as a photoelectric conversion layer used in a general photoelectric conversion module such as a solar cell. The photoelectric conversion layers 14 and 24 include, for example, a perovskite compound. The perovskite compound may be, for example, a compound represented by the following chemical formula (I).

X_{α}Y_{β}Z_{γ} (I)

In the above chemical formula (I), the ratio of α : β : γ is, for example, 3:1:1, where X represents a halogen ion, Y represents monovalent cation, and Z represents divalent cation. The perovskite layer is preferably disposed adjacent to the electron transport layer. Note that the ratio of α:β:γ may not necessarily be 3:1:1, and may be for example, 3:1.05:0.95, or 3:0.95:1.05. The ratio of α:β:γ is, for example, 3:(0.95 to 1.05):(0.95 to 1.05).

X in the above chemical formula (I) is not particularly limited and may be appropriately selected depending on the purpose, and examples thereof include halogen ions, for example, chlorine, bromine, and iodine. One of these may be used alone, or two or more of these may be used in combination.

Examples of Y in the above chemical formula (I) include an alkylamine compound ion (an organic compound having an amino group), for example, methylammonium cation, ethylammonium cation, n-butyl ammonium cation, and formamidinium cation, and in addition to such organic compounds, an alkali metal ion, for example, cesium cation, potassium cation, and rubidium cation may also be used. For the alkylamine compound ion and the alkali metal ion, one of these may be used alone, or two or more of these may be used in combination. The organic compound (alkylamine compound ion) and the inorganic compound (alkali metal ion) may be used in combination, and for example, cesium ion and formamidine may be used in combination.

Z in the above chemical formula (I) is not particularly limited and may be appropriately selected depending on the purpose, and examples thereof include a divalent metal ion, for example, lead, indium, antimony, tin, copper, bismuth, and germanium. One of these may be used alone, or two or more of these may be used in combination. Lead is particularly preferable, and more particularly, a combination of lead and tin is preferable.

The photoelectric conversion layers 14 and 24 may be formed of a perovskite compound as described above. A method for forming such a perovskite layer is not particularly limited and can be appropriately selected depending on the purpose, and may be for example, a method of coating a solution in which a metal halide and an alkylamine halide are dissolved or dispersed, and drying the coated portion.

A method for forming the perovskite layer may be, for example, a two-step precipitation method where a solution in which a metal halide is dissolved or dispersed is coated, then dried, and immersed in a solution in which an alkylamine halide is dissolved, to form a perovskite compound.

A method for forming the perovskite layer may also be, for example, a method of adding a poor solvent (a solvent having a small solubility) for the perovskite compound, while coating a solution in which a metal halide and an alkyl halide amine are dissolved or dispersed, to precipitate a crystal. A method for forming a perovskite layer may also be, for example, a method of depositing a metal halide in a gas filled with methylamine or the like.

A method for forming the perovskite layer is particularly preferred to be the method of adding a poor solvent (a solvent having a small solubility) for a perovskite compound, while coating a solution in which a metal halide and an alkyl halide amine are dissolved or dispersed, to precipitate a crystal. A method for coating these solutions is not particularly limited and may be appropriately selected depending on the purpose, and examples thereof include a spin-coating method, a dip method, a roller method, an air knife method. A method for coating the solution may be, for example, a method of performing precipitation in a supercritical fluid using carbon dioxide or the like. Examples of the poor solvent used in the aforementioned method of precipitating a crystal by adding a poor solvent include hydrocarbons, for example, n-hexane and n-octane; alcohols, for example, methanol, ethanol, and 2-propanol; ethers, for example, diethyl ether and diisopropyl ether; ketones, for example, acetone and methyl isobutyl ketone; esters, for example, ethyl acetate, isobutyl acetate, and γ-butyrolactone; nitriles, for example, acetonitrile and 3-methoxypropionitrile; aromatic hydrocarbon compounds, for example, benzene, toluene, and chlorobenzene; halogen-based solvents, for example, dichloromethane and chloroform, and fluorine-based solvents, for example. chlorofluorocarbon, hydrochlorofluorocarbon, and hydrofluorocarbon.

A method for forming the perovskite layer may further include, for example, after the formation of the perovskite layer, a process for removing the solvent (solvent removal process), or a process for disposing the perovskite crystal. Examples of the solvent removing process and the crystal disposition process include a method of blowing dry air or the like, a method of heating with a hotplate, an oven, or the like, and a method of vacuum drying. The temperature of the heating is, for example, preferably 50 to 200°C, and more preferably 70 to 180°C. The time for the heating is, for example, preferably 1 to 150 minutes, and more preferably 5 to 60 minutes. The thickness of the photoelectric conversion layers 14 and 24 is not particularly limited, but from the viewpoint of further preventing performance degradation due to defects or peeling, for example, 50 to 1500 nm is preferable, and 200 to 1000 nm is more preferable.

A method for forming the perovskite layer may include, for example, a process of treating a surface (surface treatment process) using a salt formed of one or more cations and one or more anions. Examples of the cation include inorganic cation, for example, lithium, sodium, potassium, rubidium, cesium, magnesium, and calcium; organic compounds having an amino group, for example, ammonium cation, methylamine, ethylamine, n-butylamine, isopentylamine, neopentylamine, formamidine, acetamidine, benzylamine, 2-phenylethylamine, 2-(4-methoxyphenyl)ethylamine, 4-fluorobenzylamine, 2-(4-fluorophenyl)ethylamine, 1,4-phenylenediamine, 5-aminovaleric acid, methamine, ethylenediamine, p-xylylenediamine, m-xylylenediamine, 1,2-adamantanediamine, 1,3-adamantanediamine, N,N-dimethylethylenediamine, 1,3-diaminopropane, 1,4-diazabicyclo[2.2.2]octane, guanidine, aniline, pyrrole, imidazole, 1-ethylimidazole, 2-ethylimidazole, benzmidazole, morpholine, pyrrolidine, pyrazole, triazole, and carbazole, and cations obtained from a heterocycle containing a nitrogen atom, for example, pyridine, pyrazine, pyridazine, pyrimidine, quinoline, isoquinoline, phenanthroline, 2,2'-bipyridyl, and 4,4'-bipyridyl. Examples of the anion include a halogen ion, for example, a fluorine ion, a chlorine ion, a bromic ion, and an iodine ion; a carboxylate ion, for example, a formate ion, and an acetate ion; an isocyanato ion, a thiocyanate ion, a tetrafluoroborate ion, and a hexafluorophosphate ion, and a trifluoromethanesulfonylimide ion.

The salt formed from the cation and the anion is preferably dissolved in, for example, more than one solvent. Examples of the solvents include alcohols, for example, isopropanol (2-propanol), ethanol (EtOH), methanol (MeOH), and butanol; nitriles, for example, acetonitrile and propionitrile, and an aromatic solvent, for example, toluene, chlorobenzene, and 1,2-dichlorobenzene. One of the solvents may be used alone, or two or more types of the solvents may be used in combination.

The surface treatment processed is performed by coating the solution in which the salt is dissolved on the formed perovskite layer, and drying the coated solution. A method for coating the solution is not particularly limited and can be appropriately selected depending on the purpose, and examples thereof include an immersion method, a spin-coating method, a spray method, a dip method, a roller method, and an air knife method. Heat treatment may be performed after the coating. In the case of performing the heating, the heating temperature is preferably, for example, 50 to 200°C, and more preferably 70 to 180°C. The heating time is, for example, preferably 1 to 150 minutes, and more preferably 5 to 60 minutes. The film thickness of the solution coating is not particularly limited.

### [Second electrode 16, 26]

The second electrodes 16 and 26 (which may be back electrodes, for example) are, for example, layers having a function of taking out holes or electrons from the photoelectric conversion layers 14 and 24 via the hole transport layer or the electron transport layer.

The second electrodes 16 and 26 may be formed directly on the hole transport layer 15 in the direct structure, or may be formed directly on the electron transport layer 23 in the inverted structure. The material of the second electrodes 16 and 26 is not particularly limited and may be, for example, the same material as that of the first electrodes 12 and 22. The form, the structure, and the size of the second electrodes 16 and 26 are not particularly limited, and can be appropriately selected depending on the purpose. Examples of the material of the second electrodes 16 and 26 include metal, a carbon compound, a conductive metal oxide, and a conductive polymer. Examples of the metal include platinum, gold, silver, copper, and aluminum. Examples of the carbon compound include graphite, fullerene, carbon nanotube, and graphene. Examples of the conductive metal oxide include ITO, IZO, FTO, and ATO. Examples of the conductive polymer include polythiophene and polyaniline. As the material used for forming the second electrodes 16 and 26, one of the materials above may be used alone, or two or more thereof may be used in combination.

The second electrodes 16 and 26 can be formed by an method, for example, coating, laminating, vacuum deposition, CVD, sputtering, bonding, or the like, appropriately on the hole transport layer 15 or on the electron transport layer 23, depending on the type of the material used for the second electrodes 16 and 26, and the type of the hole transport layer 15 or the electron transport layer 23,

In the photoelectric conversion module of the present invention, at least one of the first electrode 12 or 22, or the second electrode 16 or 26 is preferably substantially transparent. When using the photoelectric conversion module of the present invention, it is preferable that the electrode be transparent, and the incident light enters from the electrode side. In this case, it is preferable to use a material that reflects light for the back electrode (an electrode opposite to the transparent electrode, for example, the second electrode), and metal, glass with a conductive oxide deposited thereon, plastic, a metal thin film, or the like is preferably used. It is also effective to provide a reflection prevention layer on the electrode of the incident light side.

The configuration of the photoelectric conversion module of the present invention is not limited to the configuration of FIG. 1 or FIG. 2. For example, the support 11 may be disposed on the side opposite to the side shown in FIG. 1 (above the second electrode 16 in FIG. 1), and on the support 11, the second electrode 16, the electron transport layer 15, the photoelectric conversion layer 14, the hole transport layer 13, and the first electrode 12 may be laminated in this order. As described above, for example, between the respective layers, that is, the support 11, the first electrode 12, the hole transport layer 13, the photoelectric conversion layer 14, the electron transport layer 15, and the second electrode 16, another component may or may not necessarily be present. Although the above described is an example where the first electrode 12 is a transparent electrode and the second electrode 16 is a back surface electrode, the photoelectric conversion module of the present invention is not limited thereto. For example, in the photoelectric conversion module of the present invention, conversely, the first electrode may be a back electrode, and the second electrode may be a transparent electrode.

The total thickness of the photoelectric conversion module of the present invention can be appropriately changed depending on the thickness of the support to be used.

### [Sealing]

The photoelectric conversion module (e.g., solar cell) of the present invention is preferably sealed to protect the device from water and oxygen. The structure of the sealing is not particularly limited and may be, for example, the same as that of general photoelectric conversion modules (e.g., solar cells), and specifically, for example, only an outer periphery of the photoelectric conversion module of the present invention may be coated with a sealing material and covered with glass or a film, or the entire photoelectric conversion module may be coated with a sealing material and covered with glass or a film, or the entire photoelectric conversion module may be merely coated with a sealing material.

The material of the sealing material is not particularly limited, and can be appropriately selected depending on the purpose. For example, it is preferable to use an epoxy resin or an acrylic resin with curing, without or curing, or partial curing.

Non-limiting examples of the epoxy resin include water dispersions, solventless type, solid type, thermosetting type, curing-agent mixed type, ultraviolet-curing type. Among these, the thermosetting type and the ultraviolet-curing type are preferable, and the ultraviolet-curing type is more preferable. Note that the ultraviolet-curing type may be subjected to the heating, and the heating is preferably performed even after ultraviolet-curing. Specific examples of the type of the epoxy resin include bisphenol A, bisphenol F, novolac, cyclic aliphatic, long-chain aliphatic, glycidiamine, glycidyl ether, and glycidyl ester. One of these may be used alone, or two or more may be used in combination. It is preferable to mix a curing agent and various additives to the epoxy resin as needed. Epoxy resin compositions that are already commercially available can be used in the present invention. Among them, commercially available epoxy resin compositions that are developed especially for solar cells and organic EL devices are particularly efficient in the present invention. Examples of the commercially available epoxy resin compositions include TB3118, TB3114, TB3124, TB3125F (manufactured by ThreeBond Co., Ltd.), WorldRock^{®}5910, WorldRock^{®}5920, WorldRock^{®}8723 (manufactured by Kyoritsu Chemical & Co.,Ltd.), WB90US (P), and WB90US-HV (manufactured by MORESCO Corporation).

The acrylic resin is not particularly limited, and for example, commercially available acrylic resins developed especially for solar cells and organic EL devices can be efficiently used. Examples of the commercially available acrylic resin compositions include TB3035B, and TB3035C (manufactured by ThreeBond Co., Ltd.).

The curing agent is not particularly limited and may be appropriately selected depending on the purpose, and may be, for example, amine-based, acid anhydride-based, polyamide-based, and other curing agents. Examples of the amine-based curing agent include aliphatic polyamines, for example, diethylenetriamine and triethylenetetramine, and aromatic polyamines, for example, metaphenylenediamine, diaminodiphenylmethane, and diaminodiphenylsulfone. Examples of the acid anhydride-based curing agent include phthalic anhydride, tetra and hexahydrophthalic anhydride, methyltetrahydrophthalic anhydride, methylnadic anhydride, pyromellitic anhydride, hetic anhydride, and dodecenylsuccinic anhydride. Examples of other curing agents include imidazoles, and polymercaptan. One of these may be used alone, or two or more of these may be used in combination.

The additive is not particularly limited and may be appropriately selected depending on the purpose, and examples thereof include a filler, a gap agent, a polymerization initiator, a desiccant (moisture absorber), a curing accelerator, a coupling agent, a flexibilizer, a colorant, a flame retardant, an antioxidant, and an organic solvent. Among these, the filler, the gap agent, the curing accelerator, the polymerization initiator, and the desiccant (moisture absorbent) are preferable, and the filler and the polymerization initiator are more preferable. The filler as the additive can reduce the intrusion of moisture or oxygen, and is also effective for reducing the volume shrinkage during curing, reducing the outgas amount during curing or heating, improving the mechanical strength, and controlling thermal conductivity and fluidity. Therefore, inclusion of the filler as the additive is extremely effective in maintaining stable output in various environments.

For the output characteristics of the photoelectric conversion module and its durability, not only the influence of intruding moisture and oxygen, but also the influence of outgas generated during curing or heating of the sealing material cannot be ignored. Especially, the outgas generated during heating has a great influence on the output characteristics in storage at high temperatures. By using the filler, the gap agent, or the desiccant in the sealing material, it is possible to prevent intrusion of moisture and oxygen by those agents themselves, and also to reduce the amount of the sealing material to be used, thereby reducing the outgas. It is also efficient to use the filler, the gap agent, or the desiccant not only during curing, but also when storing the photoelectric conversion module at high temperatures.

The filler is not particularly limited and may be appropriately selected depending on the purpose, and examples thereof include crystalline or amorphous silica, silicate minerals, for example, talc, alumina, aluminum nitride, silicon nitride, calcium silicate, and inorganic fillers, for example, calcium carbonate. Among these, hydrotalcite is particularly preferable. One of these may be used alone, or two or more of these may be used in combination.

The average primary particle diameter of the filler is not particularly limited and is preferably 0.1 µm or more and 10 µm or less, and more preferably 1 µm or more and 5 µm or less. When the average primary particle diameter of the filler is within the above preferable range, it is possible to sufficiently achieve the effect of preventing moisture and oxygen from intruding, and as such, the viscosity becomes appropriate, and the adhesiveness to the substrate and the defoaming property improves, which are effective for the control of the width of the sealing section and improvement of the workability.

The content of the filler is preferably 10 pts.mass or more and 90 pts.mass or less, and more preferably 20 pts.mass or more and 70 pts.mass or less, based on the entire sealing material (100 pts.mass). When the content of the filler is within the above preferable range, the effect of preventing intrusion of moisture and oxygen can be sufficiently achieved, the viscosity can be appropriate, and as such, the adhesiveness and workability can be good.

The gap agent is also referred to as a gap control agent or a spacer agent. Inclusion of the gap material as the additive enables the control of the gap of the sealing section. For example, in the case of providing the sealing material on the first substrate or the first electrode and disposing the second substrate thereon to perform sealing, if the sealing material includes the gap agent, the gap of the sealing section can be equally the same as the size of the gap agent, so that the gap of the sealing section can be easily controlled.

The gap agent is not particularly limited and is preferably, for example, a particulate material having a uniform particle diameter, high solvent resistance, and high heat resistance, and can be appropriately selected depending on the purpose. The gap agent is preferred to be one having a high affinity with an epoxy resin and a spherical particle shape. Specifically, glass beads, silica fine particles, organic resin fine particles, and the like are preferred. One of these may be used alone, or two of these may be used in combination. The particle diameter of the gap agent can be selected in accordance with the gap of the sealing section to be set, and is preferably 1 µm or more and 100 µm or less, and more preferably 5 µm or more and 50 µm or less.

The polymerization initiator is not particularly limited and may be, for example, a polymerization initiator that uses heat or light to initiate polymerization, and can be appropriately selected depending on the purpose, and examples thereof include a thermal polymerization initiator and a photopolymerization initiator. The thermal polymerization initiator is a compound that generates active species such as radicals and cations by heating, and examples thereof include an azo compound, for example, 2,2'-azobisbutyronitrile (AIBN), and a peroxide, for example, benzoyl peroxide (BPO). As the thermal cationic polymerization initiator, a benzene sulfonic acid ester, an alkyl sulfonium salt, or the like is used. In the case of using an epoxy resin, the photopolymerization initiator is preferably a photo-cationic polymerization initiator. When the photo-cationic polymerization initiator is mixed with an epoxy resin and light irradiation is performed, the photo-cationic polymerization initiator decomposes and generates an acid, and the acid causes polymerization of the epoxy resin, and a curing reaction proceeds. The photo-cationic polymerization initiator has advantages such as a small volume shrinkage at the time of curing, no oxygen inhibition, and a high storage stability.

Examples of the photo-cationic polymerization initiator include an aromatic diazonium salt, an aromatic iodonium salt, an aromatic sulfonium salt, a metacerone compound, and a silanol-aluminum complex. The polymerization initiator may also be a photoacid generator having a function of generating an acid upon light irradiation. The photoacid generator acts as an acid for initiating cationic polymerization, and examples thereof include an onium salt such an ionic sulfonium salt system and an iodonium salt system including a cationic part and an anionic part. One of these may be used alone, or two or more of these may be used in combination.

The amount of the polymerization initiator to be added is not particularly limited and may vary depending on the material to be used, and is preferably 0.5 pts.mass or more and 10 pts.mass or less, and more preferably 1 pts.mass or more and 5 pts.mass or less, based on the entire sealing material (100 pts.mass). When the addition amount is within the preferable range described above, curing proceeds properly, and it is possible to reduce the remaining of the uncured product and excessive generation of the outgas.

The desiccant (also referred to as a moisture absorbent) is a material having a function of physically or chemically adsorbing or absorbing moisture. When the sealing material includes the desiccant, the moisture resistance can be further improved, and the influence of the outgas can be reduced. The desiccant is not particularly limited and can be appropriately selected depending on the purpose, and is preferably particulate, and examples thereof include an inorganic water absorbing material, for example, calcium oxide, barium oxide, magnesium oxide, magnesium sulfate, sodium sulfate, calcium chloride, silica gel, molecular sieve, and zeolite. Among these, zeolite that can absorb a large amount of moisture is preferable. One of these may be used alone, or two or more of these may be used in combination.

The curing accelerator (also referred to as a curing catalyst) is a material that accelerates the curing speed, and is mainly used for a thermosetting epoxy resin. The curing accelerator is not particularly limited and may be appropriately selected depending on the purpose, and examples thereof include a tertiary amine or a tertiary amine salt, for example, DBU (1,8-diazabicyclo(5,4,0)-undecene-7) and DBN (1,5-diazabicyclo(4,3,0)-nonene-5), an imidazole system, for example, 1-cyanoethyl-2-ethyl-4-methylimidazole, and 2-ethyl-4-methylimidazole, and phosphine or a phosphinium salt, for example, triphenylphosphine, and tetraphenylphosphonium tetraphenylborate. One of these may be used alone, or two or more of these may be used in combination.

The coupling agent is not particularly limited as long as it is a material with an effect of increasing the molecular bonding force, and can be appropriately selected depending on the purpose, and may be, for example, a silane coupling agent or the like. Specific examples of the silane coupling agent include 3-glycidoxypropyltrimethoxysilane, 3-glycidoxypropylmethyldimethoxysilane, 3-glycidoxypropylmethyldimethoxysilane, 2-(3,4-epoxycyclohexyl)ethyltrimethoxysilane, N-phenyl-γ-aminopropyltrimethoxysilane, N-(2-aminoethyl)3-aminopropylmethyldimethoxysilane, N-(2-aminoethyl)3-aminopropylmethyltrimethoxysilane, 3-aminopropyltriethoxysilane, 3-mercaptopropyltrimethoxysilane, vinyltrimethoxysilane, N-(2-(vinylbenzylamino)ethyl)3-aminopropyltrimethoxysilane hydrochloride, and 3-methacryloxypropyltrimethoxysilane. One of these may be used alone, or two or more of these may be used in combination.

In the present invention, for example, a sheet-like adhesive can be used. The sheet-like adhesive is, for example, a sheet with a resin layer formed thereon in advance. The sheet may be glass, a film having a high gas barrier property, or the like. The sheet may also be formed only of a sealing resin. It is also possible to bond the sheet-like adhesive on a sealing film. It is also possible to prepare a structure where a hollow section is provided on the sealing film before bonding it to a device.

When using the sealing film for sealing, the sealing film is disposed so at to face the support via the photoelectric conversion device. The form, the structure, the size, and the type of a base material of the sealing film are not particularly limited, and can be appropriately selected depending on the purpose. The sealing film includes a barrier layer, which prevents moisture and oxygen from passing through the film formed on a surface of the base material. The barrier layer may be formed on only one side or both sides of the base material.

The barrier layer may be formed of, for example, a material including metal oxide, metal, a mixture formed of a polymer and metal alkoxide, or the like as a main component. Examples of the metal oxide include aluminum oxide, silicon oxide, and aluminum. Examples of the polymer include polyvinyl alcohol, polyvinyl pyrrolidone, and methylcellulose. Examples of the metal alkoxide include tetraethoxysilane, triisopropoxyaluminum, 3-glycidoxypropyltrimethoxysilane, 3-mercaptopropyltrimethoxysilane, and 3-isocyanatopropyltriethoxysilane.

The barrier layer may be, for example, transparent or opaque. The barrier layer may be a single layer, or may have a laminated structure, formed of a combination of the above materials. A method for forming the barrier layer may be a known method, for example, a vacuum film forming method including a sputtering method, or a coating method including a dipping method, a roll-coating method, a screen-printing method, a spray method, and a gravure printing method.

### [Wiring]

In the photoelectric conversion module of the present invention (e.g., solar cell), the electrode and the back electrode are preferably connected with lead wire (wiring), in order to efficiently take out the current generated by light. The lead wire is, for example, connected to the first electrode and the second electrode using a conductive material, for example, solder, silver paste, or graphite. The conductive material may be used alone, or used in a mixed or laminated structure of two or more types. The part attached with the lead wire may be covered with an acrylic resin or an epoxy resin, from the viewpoint of physical protection.

Lead wire is a generic term of electric wire for electrically connecting power source, electronic components, and the like in electric circuits, and examples thereof include vinyl wire, and enameled wire.

### [Application]

Application and usage of the photoelectric conversion module of the present invention are not particularly limited. The photoelectric conversion module may be, for example, widely used in the same application as general photoelectric conversion modules (e.g., general solar cells). The photoelectric conversion module of the present invention (e.g., solar cell) can be, for example, applied to a power supply by being combined with a circuit board or the like for controlling the generated current. Examples of devices using a power supply include electronic desktop calculators and solar-powered wristwatches. The photoelectric conversion module of the present invention is also applicable to mobile phones, electronic papers, thermo-hygrometers, or the like, as a power supply. The photoelectric conversion module of the present invention is also applicable to nighttime use by being combined with auxiliary power sources or secondary batteries for extending the time of continuous use of electric appliances with rechargeable or dry batteries. Further, the photoelectric conversion module of the present invention is also available as an independent power source that does not require battery replacement or power source wiring.

### Examples

Next, examples of the present invention will be described below. It is to be noted, however, that the present invention is by no means limited to the following examples.

### [Example 1]

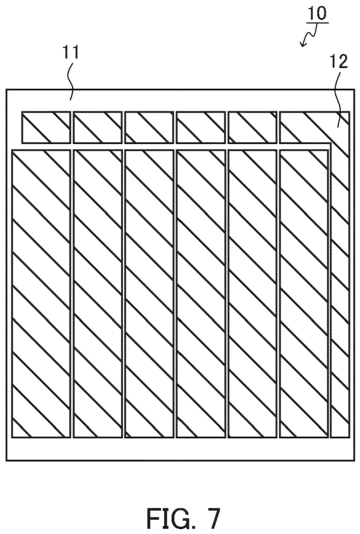

On an ITO glass substrate of which a first electrode is patterned into the form shown in FIG. 7 (glass substrate as a support (thickness: 0.7 mm) with the first electrode formed thereon) in advance, a colloidal SnO₂ aqueous solution (manufactured by Alpha Aesar) was coated by spin-coating, and dried at 100°C, to obtain an electron transport layer (not shown). Note that although a glass substrate was used in the present invention, another substrate such as a substrate using a plastic film according to the embodiments may be used. There was no difference in the performance of the photoelectric conversion module of the present invention even when the substrate is changed. Next, cesium iodide (0.738 g), formamidine iodide (7.512 g), methylamine bromide (0.905 g), lead iodide (23.888 g), and lead bromide (1.022 g) were dissolved in N,N-dimethylformamide (DMF, 40.0 mL) and dimethyl sulfoxide (DMSO, 12.0 mL), and the dissolved solution was formed into a film on the aforementioned substrate using spin-coating. The spin-coating was performed at a rotational speed of 3000 rpm. 30 seconds after the spin-coating started, chlorobenzene (0.3 mL) was dropped onto the coating layer of the substrate. Thereafter, the substrate was heated at 150°C for 10 minutes to obtain a perovskite layer (Cs_{0.05}FA_{0.50}MA_{0.15}Pbl_{2.49}Br_{0.51}) as a photoelectric conversion layer.

Then, spiro-OMeTAD (72.3 mg), [tris(2-(1H-pyrazol-1-yl)-4-tert-butylpyridine)cobalt(III)tris(bis(trifluoromethylsulfonyl)imide)] (FK209, manufactured by FUJIFILM Wako Pure Chemical Corporation, 13.5 mg), 4-tert-butylpyridine (28.8 µL), and lithium bis(tolufluoromethylsulfonyl)imide (LiTFSI, 9.1 mg) were dissolved in chlorobenzene (1 mL), and a layer of the dissolved solution was formed on the photoelectric conversion layer by spin-coating, and heated and dried at 70°C for 30 minutes to obtain a hole transport layer (not shown). Thereafter, etching (removal) of the photoelectric conversion layer (perovskite layer) was performed using a laser processing device to form a pattern in the photoelectric conversion layer (perovskite layer) as shown in FIG. 8.

Finally, 80 nm of gold was formed by vacuum deposition, and etching (removing) of the second electrode was performed using a laser processing device to obtain a photoelectric conversion module (perovskite photovoltaic module) having a form as shown in FIG. 9. The layer thickness of the configuration excluding the glass substrate of the obtained photoelectric conversion layer was 1.1 µm. Further, the area ratio S was 0.2.

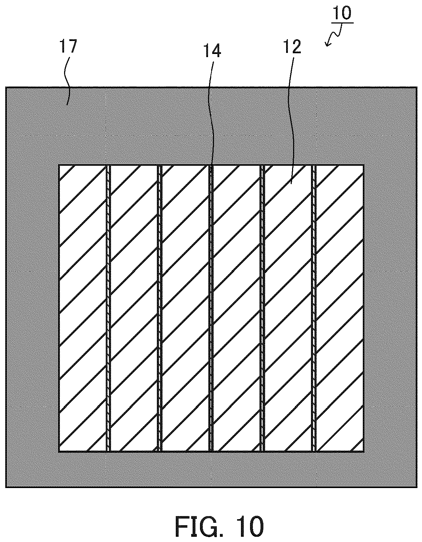

As shown in FIG. 10, on the obtained photoelectric conversion module, a mask was attached to the light-receiving surface side so as to hide only the bypass section (diode section in the reverse direction, upper part in FIG. 9).

The photoelectric conversion module prepared by the above-described procedure was irradiated by a solar simulator (SMO-250III, manufactured by Bunkoukeiki Co.,Ltd., light intensity 100 mW/cm²) combined with an air mass filter equivalent to AM 1.5 G, and the voltage and the current were measured using a source meter (2400 series, manufactured by Keithley). The results showed that the voltage was 6.62 V, and the current was 27.8 mA (Table 1).

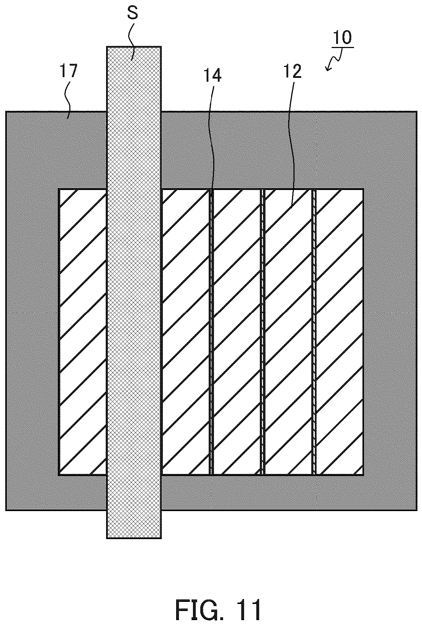

Next, as shown in FIG. 11, one cell section of the prepared module was shaded with a shading member (shadow) S, and irradiated with the same light with the above conditions to measure the voltage and the current. The results showed that the voltage was 5.51 V, and the current was 27.7 mA (Table 1).

### [Example 2]

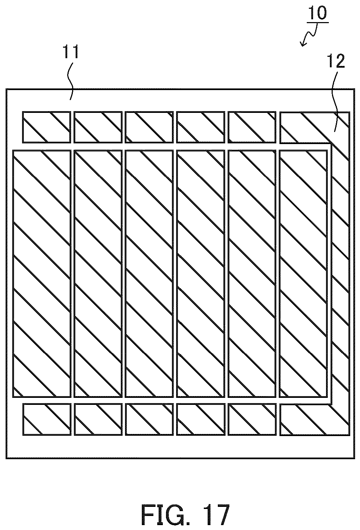

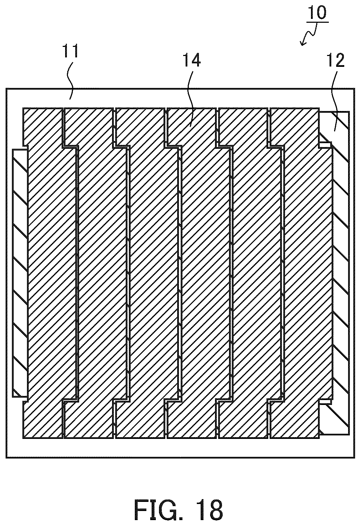

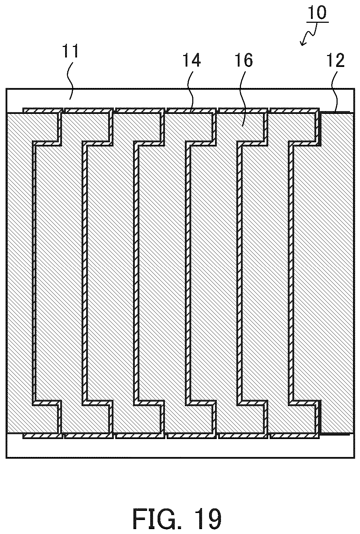

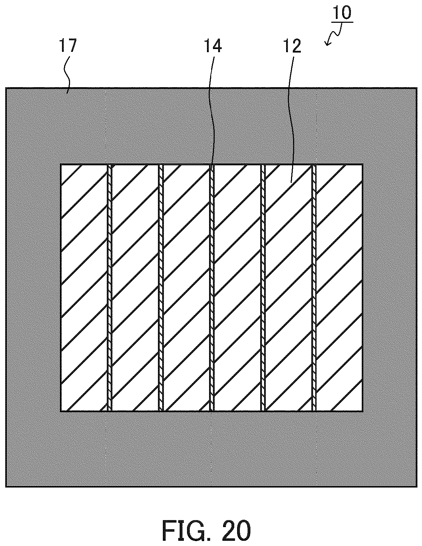

The formation patterns of the first electrode, the electron transport layer, the photoelectric conversion layer, the hole transport layer, and the second electrode were changed as shown in FIGs. 17 to 19, and a photoelectric conversion module was formed in the same manner as in Example 1 except that the module was formed to have a bypass diode function at two sections (e.g., an upper part and a lower part in FIG. 19 are bypass sections). As shown in FIG. 20, a mask was attached to the light-receiving surface of the obtained photoelectric conversion module, to measure the voltage and the current in the same manner as that in Example 1. The results showed that the voltage was 6.67 V, and the current was 24.4 mA (Table 1).

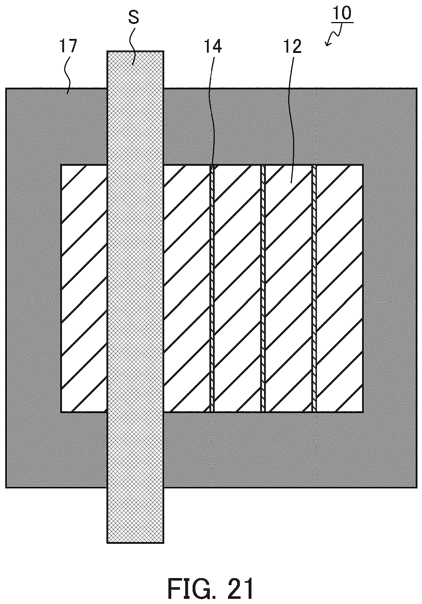

Then, as shown in FIG. 21, one cell section was shaded to measure the voltage and the current in the same manner as in Example 1. The results showed that the voltage was 5.53 V, and the current was 24.3 mA (Table 1).

### [Comparative Example 1]

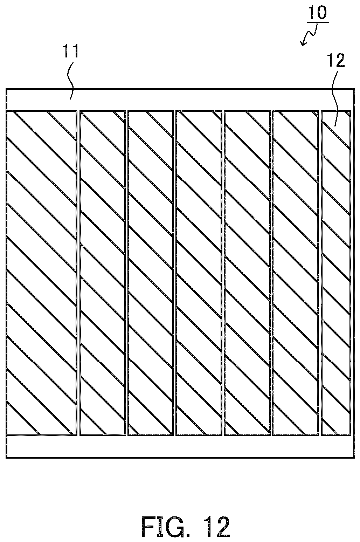

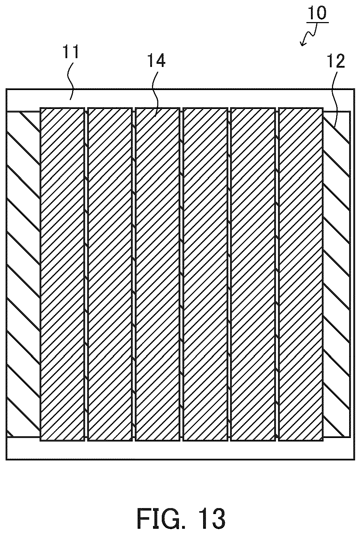

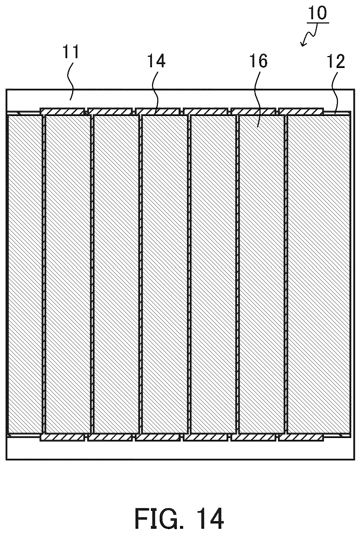

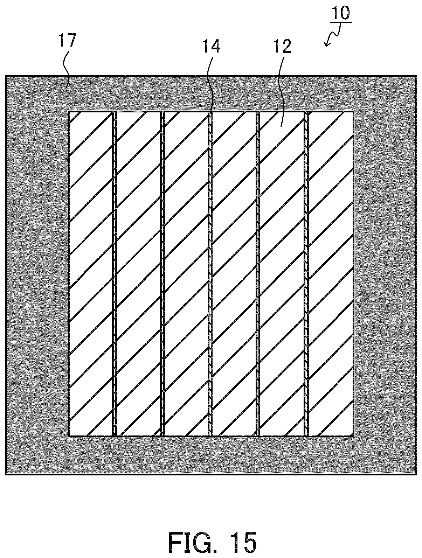

The formation patterns of the first electrode, the electron transport layer, the photoelectric conversion layer, the hole transport layer, and the second electrode were changed as shown in FIGs. 12 to 14, and a photoelectric conversion module was formed in the same manner as in Example 1 except that the module was formed to have no bypass diode function. As shown in FIG. 15, a mask was attached to the light-receiving surface of the obtained photoelectric conversion module to measure the voltage and the current in the same manner as that in Example 1. The results showed that the voltage was 6.61 V, and the current was 30.2 mA (Table 1).

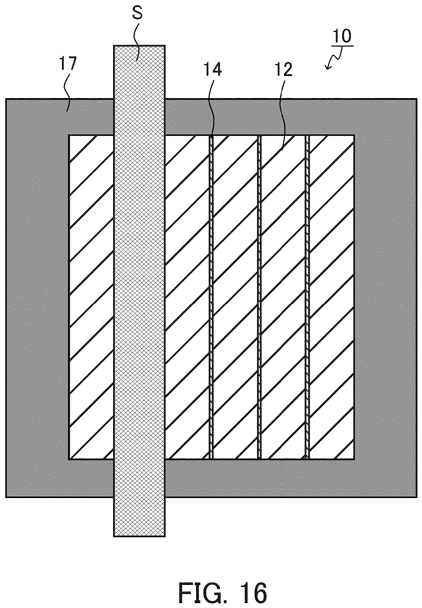

Then, as shown in FIG. 16, one cell section was shaded to measure the voltage and the current in the same manner as that in Example 1. The results showed that the voltage was 4.63 V, and the current was 0.002 mA (Table 1).

### [Comparative Example 2]

A photoelectric conversion module was prepared in the same manner as in Example 1, except that the area ratio S was set to be 1.0.

**[Table 1]**

| | Voltage (V) | | | Current (mA) | | |
|---|---|---|---|---|---|---|
| | Before shading | After shading | Before shading - After shading | Before shading | After shading | Before shading - After shading |
| Example 1 | 6.62 | 5.51 | -1.11 | 27.8 | 27.7 | -0.1 |
| Example 2 | 6.67 | 5.53 | -1.14 | 24.4 | 24.3 | -0.1 |
| Comparative example 1 | 6.61 | 4.63 | -1.98 | 30.2 | 0.002 | -30.198 |

Comparing the voltage before and after the shading in Example 1, although the voltage corresponding to one cell was decreased, it was found that the voltage value hardly changed. Thus, the bypass section (diode section in the reverse direction) prepared in this case was found to function as a bypass diode. Further, since the bypass diode function is in the plane parallel to the light-receiving surface, the entire photoelectric conversion module is less uneven. Thus, the part that hinders adhesion with walls or the like is reduced, thereby imparting flexibility and achieving practicability.

Comparing the voltage before and after the shading in Example 2, although the voltage corresponding to one cell was decreased, it was found that the voltage value hardly changed. Thus, the two bypass sections (diode section in the reverse direction) prepared in this case were found to function as a bypass diode. Similarly to Example 1, since the bypass diode function is in the plane parallel to the light-receiving surface, the entire photoelectric conversion module is less uneven. Thus, the part that hinders adhesion with walls or the like is reduced, thereby imparting flexibility and achieving practicability.

On the other hand, in Comparative Example 1, when comparing the voltage and the current before and after the shading, the voltage decreases an amount of slightly more than that corresponding to one cell, and the current value was hardly detected. This phenomenon occurs because the one cell exists as a resistant body due to the shading. Therefore, in Comparative Example 1, while the photoelectric conversion module had flexibility, depending on the provided system, an excessive voltage may have been applied to the module from the neighboring circuits, and if this situation continued, there was a risk that a hot spot may have been generated.

In Comparative Example 2, since the area of the power generation section was too small as compared to the area of the entire module, the result of the obtained output was low, which was not preferable.

As described above, the working examples showed that the photoelectric conversion module of the present invention has a bypass diode function without losing flexibility. In other words, while achieving flexibility, the generation of hotspots can be prevented even when the cell is shaded, and thus a photoelectric conversion module with stable performance can be obtained. Therefore, for example, it is possible to ensure long-term reliability. Further, since there is no need for additionally providing a bypass diode as in conventional photoelectric conversion modules, for example, it is also possible to reduce the weight of the photoelectric conversion module.

As described above, the present invention was described with reference to embodiments and examples. However, the present invention is by no means limited to the embodiment and examples described above, and combinations, changes, and selections may be made freely and appropriately without departing from the scope of the present invention as necessary.

### <Supplementary Notes>

The whole or part of the example embodiments disclosed above can be described as, but not limited to, the following supplementary notes.

### (Supplementary Note 1)

A photoelectric conversion module, including:
a power generation section, and
a bypass section, wherein
each of the power generation section and the bypass section includes:
   a first electrode,
   a photoelectric conversion layer, and
   a second electrode,
   the first electrode, the photoelectric conversion layer, and the second electrode are laminated in the described order,
   each of the power generation section and the bypass section has a diode function, and diode direction of the power generation section and the bypass section are opposite to each other in a plane parallel to a light-receiving surface.

### (Supplementary Note 2)

The photoelectric conversion module according to Supplementary Note 1, wherein
at least one of the first electrode, the photoelectric conversion layer, or the second electrode in the power generation section and the bypass section are formed of a same material to each other.

### (Supplementary Note 3)

The photoelectric conversion module according to Supplementary Note 1 or 2, wherein
each of the power generation section and the bypass section further includes a support.

### (Supplementary Note 4)

The photoelectric conversion module according to Supplementary Note 3, wherein
at least one of the support, the first electrode, the photoelectric conversion layer, and the second electrode in the power generation section and the bypass section are made of a same material to each other.

### (Supplementary Note 5)

The photoelectric conversion module according to any one of Supplementary Note 1 to 4, wherein
an area ratio S (Sb/Sp) between a total area of the plane parallel to the light-receiving surface in the power generation section (Sp), and a total area of the plane parallel to the light-receiving surface in the bypass section (Sb) is 0.2 or less.

### (Supplementary Note 6)

The photoelectric conversion module according to any one of Supplementary Note 1 to 5, wherein
at least a part of the bypass section is shaded.

### (Supplementary Note 7)

The photoelectric conversion module according to any one of Supplementary Note 1 to 6, wherein
the photoelectric conversion layer has a perovskite structure represented by following chemical formula (I),

   X_{α}Y_{β}Z_{γ} (I)
in the chemical formula (I), X represents a halogen ion, Y represents monovalent cation, Z represents divalent cation, and
a ratio of α:β:γ is 3:(0.95 to 1.05):(0.95 to 1.05).

### (Supplementary Note 8)

The photoelectric conversion module according to Supplementary Note 7, wherein
the monovalent cation represented as Y in the chemical formula (I) includes at least one cation selected from the group consisting of a cesium cation, a rubidium cation, a potassium cation, a methylammonium cation, and a formamidinium cation.

### (Supplementary Note 9)

The photoelectric conversion module according to any one of Supplementary Note 1 to 8, as a solar cell.

### Industrial Applicability

As described above, the present invention can provide a photoelectric conversion module having a bypass diode function without losing flexibility. The photoelectric conversion module of the present invention is, for example, useful as a solar cell. Application and usage of the photoelectric conversion module of the present invention are not particularly limited, and can be applied in a broad range of fields, with the same application and usage as general photoelectric conversion modules (e.g., general solar cells).

This application claims priority from Japanese Patent Application No. 2022-194516 filed on December 5, 2022. The entire subject matter of the Japanese Patent Application is incorporated herein by reference.

### Reference Signs List

- 10, 20: photoelectric conversion module
- 11, 21: support
- 12, 22: first electrode
- 13, 23: electron transport layer
- 14, 24: photoelectric conversion layer
- 15, 25: hole transport layer
- 16, 26: second electrode
- 17,: mask
- S: shading member (shade)

## Claims

1. A photoelectric conversion module, comprising:
a power generation section, and
a bypass section, wherein
each of the power generation section and the bypass section includes:
a first electrode,
a photoelectric conversion layer, and
a second electrode,
the first electrode, the photoelectric conversion layer, and the second electrode are laminated in the described order,
each of the power generation section and the bypass section has a diode function, and
diode direction of the power generation section and the bypass section are opposite to each other in a plane parallel to a light-receiving surface.

2. The photoelectric conversion module according to Claim 1, wherein
at least one of the first electrode, the photoelectric conversion layer, or the second electrode in the power generation section and the bypass section are formed of a same material to each other.

3. The photoelectric conversion module according to Claim 1 or 2, wherein
each of the power generation section and the bypass section further includes a support.

4. The photoelectric conversion module according to Claim 3, wherein
at least one of the support, the first electrode, the photoelectric conversion layer, and the second electrode in the power generation section and the bypass section are made of a same material to each other.

5. The photoelectric conversion module according to Claim 1 or 2, wherein
an area ratio S (Sb/Sp) between a total area of the plane parallel to the light-receiving surface in the power generation section (Sp), and a total area of the plane parallel to the light-receiving surface in the bypass section (Sb) is 0.2 or less.

6. The photoelectric conversion module according to Claim 1 or 2, wherein
at least a part of the bypass section is shaded.

7. The photoelectric conversion module according to Claim 1 or 2, wherein
the photoelectric conversion layer has a perovskite structure represented by following chemical formula (I),
X_{α}Y_{β}Z_{γ} (I)
in the chemical formula (I), X represents a halogen ion, Y represents monovalent cation, Z represents divalent cation, and
a ratio of α:β:γ is 3:(0.95 to 1.05):(0.95 to 1.05).

8. The photoelectric conversion module according to Claim 7, wherein
the monovalent cation represented as Y in the chemical formula (I) includes at least one cation selected from the group consisting of a cesium cation, a rubidium cation, a potassium cation, a methylammonium cation, and a formamidinium cation.

9. The photoelectric conversion module according to Claim 1 or 2, as a solar cell.
